# FASCICULE DE BREVET EUROPEEN

(11) **EP 0 786 860 B1**
(45) Date de publication et mention de la délivrance du brevet: **14.04.1999**
(21) Numéro de dépôt: 97400155.4
(22) Date de dépôt: 23.01.1997
(51) Int. Cl.: H03G 3/34

(54) **Recepteur radio comportant un circuit de blocage automatique**
Empfänger mit automatischer Rauschsperre
Receiver with automatic squelch

(30) Priorité: 25.01.1996 FR 9600857
(43) Date de publication de la demande: 30.07.1997
(73) Titulaire: Groupe Président Electronics, 34540 Balaruc (FR)
(72) Inventeur: Bertrana, Albert, 66000 Perpignan (FR)
(74) Mandataire: Caron, Gérard

(56) Documents cités:
- US-A- 2 770 721
- US-A- 3 979 679
- US-A- 4 044 309
- ELEKTOR ELECTRONICS, vol. 21, no. 238, 1 Novembre 1995, pages 18-22, XP000543300 MEYER S: "FM NOISE SQUELCH"

## Description

La présente invention est relative à un circuit de blocage à réglage automatique pour un récepteur radio conçu pour recevoir des communications dont l'apparition dans le temps est aléatoire.

Un exemple type d'un tel récepteur radio est le dispositif qui, à l'heure actuelle, fait partie d'un ensemble émetteur/récepteur fonctionnant notamment en modulation d'amplitude et destiné à assurer les communications hertziennes, en particulier vocales, entre les particuliers. Les fréquences utilisées à cet effet se situent, selon les pays, entre 26 et 28 MHz, bande de fréquences qui est habituellement désignéé par l'expression anglo-saxonne de "citizen's band" (littéralement en français "bande des particuliers" ou "des citoyens").

Les instants auxquels apparaissent les communications établies dans cette bande de fréquences sont, par essence, aléatoires de sorte que pour être capable de recevoir des communications, le récepteur doit, après avoir été réglé sur un canal donné de la bande de fréquences en question, être mis dans un état de veille pour être capable, si un correspondant se présente sur ce canal, de restituer le message auquel l'utilisateur pourra éventuellement répondre par l'intermédiaire de l'émetteur de son installation. Par conséquent, le haut-parleur ou autre transducteur sonore branché sur le récepteur, doit en permanence être connecté à la sortie du récepteur en état de veille.

Ainsi, lorsqu'un tel ensemble émetteur/récepteur fonctionne en modulation d'amplitude, sans prendre des mesures particulières, le récepteur appliquerait à ce haut-parleur, non seulement le cas échéant un signal vocal utile, mais également en permanence un signal sonore produit par le récepteur à partir de tous les signaux parasites et bruits atmosphériques atteignant l'antenne de réception. Dans ces conditions, l'utilisateur entendrait constamment un bruit de fond contenant toute une gamme de fréquences audibles (bruit blanc), ce qui serait extrêmement désagréable à la longue.

C'est pourquoi, depuis fort longtemps, il est connu d'équiper ce genre de récepteurs d'un circuit de blocage automatique (appelé "squelch" dans le vocabulaire anglo-saxon). Ce dispositif est capable de réduire automatiquement l'intensité du son émis par le transducteur sonore en l'absence de signal utile et de rétablir cette intensité sonore dès que le signal reçu présente un niveau suffisant.

D'après le document US-2 770 721, on connaît un récepteur radio équipé d'un circuit de blocage automatique. Celui-ci est commandé par une tension élaborée notamment à partir de deux composantes de tension formées de la façon suivante.

A la sortie du détecteur est branché un filtre qui discrimine dans le spectre fourni par le détecteur une bande de fréquences débutant à une fréquence vocale de 1000 Hz. Le signal de sortie du filtre est amplifié et redressé fournissant ainsi la première composante de tension du signal de commande de blocage automatique.

Le récepteur radio antérieur est décrit par référence à deux versions, l'une pour la modulation de fréquence et l'autre pour la modulation d'amplitude. Dans sa version modulation de fréquence, le récepteur comporte au moins un limiteur dont on dérive la seconde composante de tension destinée à former avec la première composante de tension la tension résultante déjà mentionnée de commande de blocage.

En outre, l'amplificateur raccordé au filtre destiné à l'élaboration de la première composante de tension comporte un dispositif de réglage manuel du seuil de silence que l'on veut imposer au système, seuil à partir duquel le circuit de commande de blocage entre en action.

Le document en question présente également un schéma d'un récepteur fonctionnant en modulation d'amplitude. On sait que dans le cas d'un tel récepteur, il n'existe ordinairement pas de limiteur d'amplitude. Or, dans cette deuxième version de récepteur décrite au document en discussion, on rajoute deux limiteurs d'amplitude (dont on peut normalement se dispenser dans un récepteur en modulation d'amplitude), afin de pouvoir disposer néanmoins de la seconde composante de tension évoquée ci-dessus pour pouvoir, par un artifice, engendrer néanmoins le signal de commande de blocage de la même façon que celle proposée dans le cadre du récepteur en modulation de fréquence.

Dans les deux versions de récepteur décrites dans le brevet US 2 770 721, le seuil de silence peut être ajusté manuellement par l'utilisateur par l'intermédiaire d'un potentiomètre qui est associé à l'amplificateur amplifiant le signal de bruit prélevé à la sortie du détecteur.

Outre le fait que la version pour modulation d'amplitude est ainsi inutilement complexe du fait de la présence de deux limiteurs d'amplitude, il présente plusieurs autres inconvénients. Tout d'abord, on sait qu'en modulation d'amplitude, le niveau de bruit dans le signal atteignant l'antenne du récepteur n'est pas constant et dépend de toute une série de facteurs très aléatoires, tels que, par exemple, l'heure du jour en raison des mouvements des hautes couches atmosphériques, les conditions de réception locales, surtout si le récepteur est embarqué sur un véhicule (passage sous un tunnel ou un pont), l'apparition des taches sur le soleil, les modifications des conditions de propagation, etc.

C'est pourquoi en l'absence d'un réglage automatique un réglage manuel du seuil de silence est utile pour que l'utilisateur puisse tant bien que mal s'adapter à ces conditions changeantes du niveau de bruit dans le signal reçu. Cependant, comme dans le document antérieur, un réglage automatique est prévu, l'utilisateur, par la présence d'un réglage manuel, risque de perturber le réglage automatique. En effet, l'utilisateur risque ainsi de régler le seuil de silence à un moment où le bruit reçu est fort avec pour résultat que ce bruit fort, mais aussi tous les signaux utiles inférieurs au niveau réglé seront supprimés. Cependant, si le bruit reçu diminue par la suite, l'utilisateur ne s'en apercevra pas car le récepteur reste silencieux, alors que les signaux utiles d'émissions reçues d'un niveau moyen ne sont plus noyés dans le bruit qui a diminué. Ces émissions pourraient donc être reçues normalement, mais elles seront supprimées du fait que le réglage manuel du système de blocage automatique n'aura pas été réajusté pour le nouveau niveau inférieur de bruit. L'automatisme ne peut alors plus jouer son rôle.

Un autre inconvénient du recepteur antérieur (que ce soit en version modulation de fréquence ou en version modulation d'amplitude), réside dans le fait que la formation de la première composante de tension du signal de commande de blocage est réalisée sur la base d'une grande partie de l'énergie représentée par les fréquences vocales utiles, typiquement à partir de 1000 Hz. Le blocage automatique pourrait ainsi intervenir intempestivement si le signal utile contient une part importante de ces fréquences plus élevées du spectre vocal transmis par le système de radiocommunication. C'est pourquoi ce récepteur antérieur doit en compensation engendrer une troisième composante de tension intervenant dans l'élaboration de la tension de commande de blocage, agissant en opposition par rapport à la première composante et basée sur les fréquences basses contenues dans le spectre vocal. Il en résulte une complication supplémentaire du montage et le risque d'une déformation de l'information utile que l'utilisateur devrait normalement recevoir, si cette information est composée exclusivement ou par moments seulement, de fréquence supérieures à 1000 Hz.

L'invention a pour but de remédier à tous ces inconvénients décrits et de fournir un circuit de blocage automatique pour un récepteur radio dans lequel le réglage du seuil de silence intervient entièrement automatiquement.

L'invention a donc pour objet un récepteur radio présentant les caractéristiques de la revendication 1.

Grâce à ces caractéristiques, le seuil de silence est déterminé entièrement automatiquement à chaque instant, sans que l'utilisateur ait à régler manuellement ce seuil, un signal parvenant au haut-parleur du récepteur uniquement si le rapport signal/bruit présente une valeur acceptable pour une écoute satisfaisante de l'information utile.

Il est connu par ailleurs par le brevet US 4 044 309 d'utiliser un circuit de blocage automatique dans lequel on prévoit de produire un signal engendré à partir de la sortie du détecteur par l'intermédiaire d'un filtre accordé sur une bande de 4 000 à 15 000 Hz, c'est-à-dire en dehors de la bande de fréquences vocales. Toutefois, dans ce cas, le signal issu du filtre est comparé à un niveau de signal vocal et le signal de blocage est engendré en fonction de cette comparaison.

Or, un tel circuit de blocage provoque seulement une atténuation partielle du signal audiofréquence envoyé dans le transducteur sonore dans tous les cas où l'émetteur reçu n'est pas modulé et notamment également si le locuteur côté émetteur réfléchit ou "cherche ses mots". Ceci provoque un claquement très désagréable dans le transducteur sonore, chaque fois que le circuit atténue brusquement le signal, lorsque le locuteur arrête de parler alors que l'émetteur reste en émission et que le circuit restaure la reproduction quand le locuteur reprend la parole.

Des particularités supplémentaires du récepteur radio selon l'invention sont définies dans les sous-revendications.

D'autres caractéristiques et avantages de l'invention apparaîtront au cours de la description qui va suivre, donnée uniquement à titre d'exemple et faite en se référant aux dessins annexés sur lesquels:
- la figure 1 est un schéma partiel très simplifié d'un récepteur radio équipé d'un circuit de blocage à réglage automatique suivant l'invention;
- la figure 2 montre plusieurs graphiques explicatifs destinés à illustrer le fonctionnement d'un circuit de blocage automatique avec réglage manuel du seuil de silence et d'un circuit de blocage automatique selon l'invention, à réglage entièrement automatique du seuil de silence;
- la figure 3 est un schéma détaillé des moyens de filtrage et de détection destinés à être utilisés dans le récepteur de la figure 1;
- les figures 4A à 4C montrent des graphiques illustrant le principe de mise en oeuvre de l'invention; et
- la figure 5 montre une variante de réalisation selon l'invention.

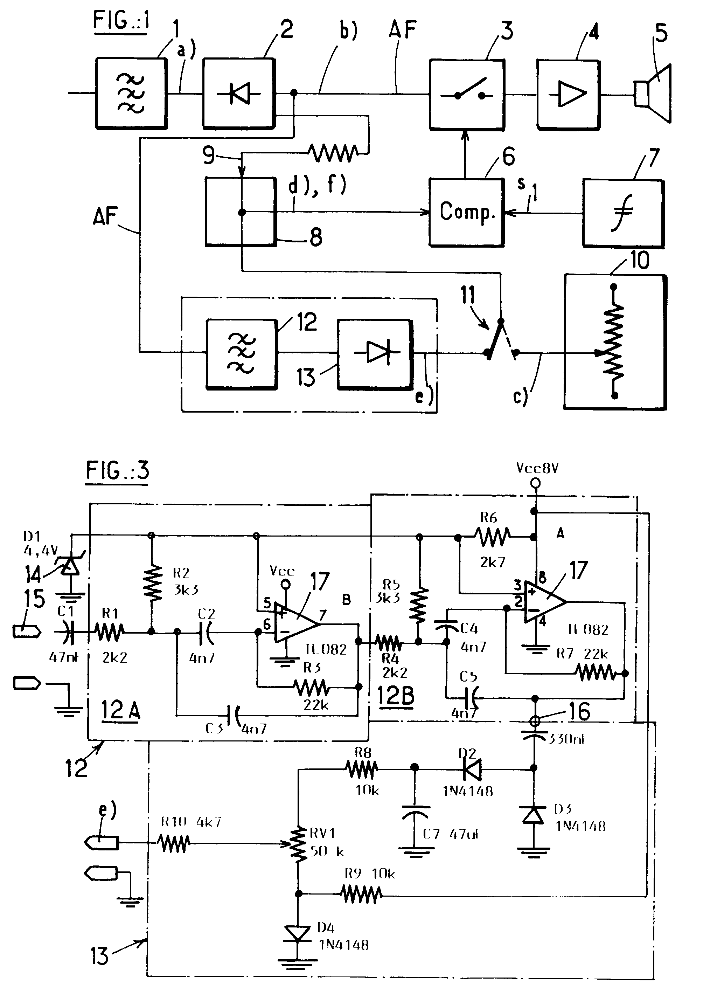

La figure 1 est un schéma partiel d'un récepteur radio équipé d'un circuit de blocage automatique à réglage automatique du seuil de silence selon l'invention. Classiquement, ce récepteur comprend les circuits d'accord habituels dont seulement le dernier est représenté en 1 et constitue l'étage de fréquence intermédiaire.

Cet étage de fréquence intermédiaire 1 est connecté à un détecteur 2 suivi d'un circuit interrupteur commandé 3. Ce dernier est connecté à un étage d'amplification de puissance 4 attaquant un haut-parleur 5, l'ensemble étant connu en soi. Le détecteur 2 délivre un signal audiofréquence et une tension continue dont le niveau représente le niveau haute fréquence reçu,

Le circuit interrupteur commandé 3 est connecté à un comparateur 6 destiné à comparer une valeur de seuil fixe établie dans un circuit à seuil 7 à un signal de somme établi sur un noeud de sommation 8.

Ce noeud de sommation 8 reçoit d'une part une tension continue représentant le niveau HF par l'intermédiaire de la liaison 9 reliée au détecteur 2 et d'autre part un signal de réglage automatique Vb. Dans le cadre de l'invention, cette tension peut accessoirement être fournie par un circuit de réglage manuel 10 qui comporte un potentiomètre réglable manuellement, mais on soulignera que ce circuit de réglage manuel peut tout à fait être omis en pratique, sa seule raison d'être ici étant de pouvoir illustrer les avantages de l'invention par rapport à un circuit plus classique tel que celui représenté sur la figure 1, lorsque le circuit fonctionne en mode manuel.

Pour le besoin de l'explication, la tension prélevée sur le curseur de ce potentiomètre 10 peut être appliquée au noeud 8 par l'intermédiaire d'un inverseur 11 que l'on suppose pour le moment être placé dans la position "Manuelle" représentée en pointillés.

Le résultat de la sommation est comparé à un seuil de blocage fourni par le circuit 7 dans le comparateur 6 dont le signal de sortie commande le circuit interrupteur commandé 3.

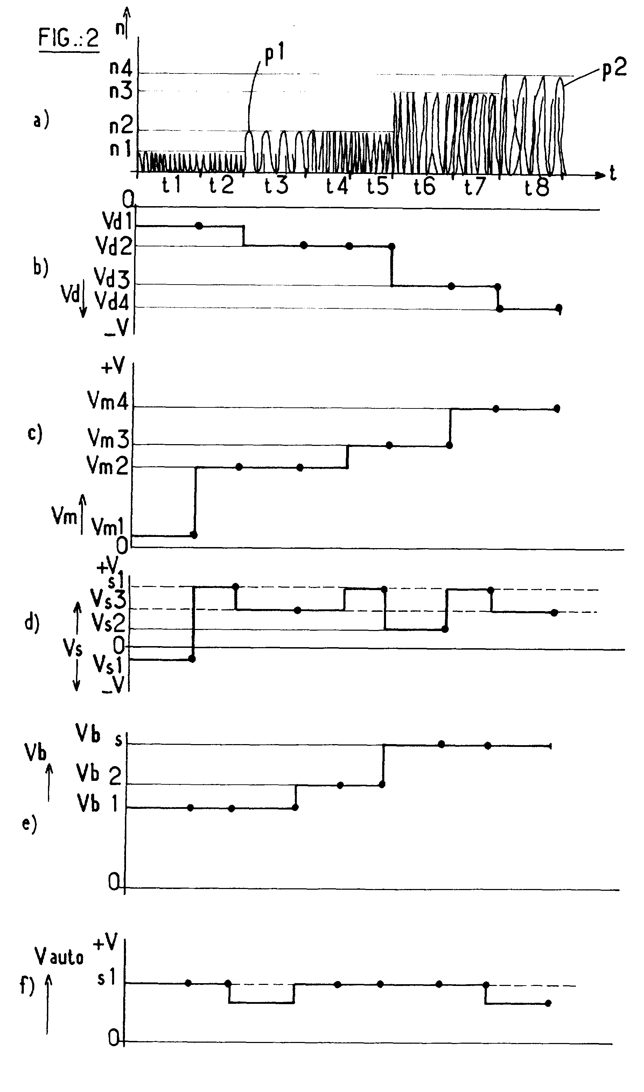

La figure 2 illustre en fonction du temps le comportement de la partie du circuit de la figure 1 dont on vient de donner une description. L'échelle des temps est divisée en huit périodes tl à t8 dont chacune correspond à un cas pouvant se présenter pendant que le récepteur est à l'écoute de communications utiles. Les longueurs des périodes ont été choisies arbitrairement à des valeurs différentes pour montrer que dans la réalité les périodes peuvent avoir des longueurs dépendant uniquement des circonstances.

Les graphiques de la figure 2 montrent les tensions apparaissant aux points du schéma de la figure 1 désignés par les mêmes références littérales a) à f). Le graphique représenté en a) montre le niveau HF, les exemples p1 et p2 faisant apparaître que le signal reçu utile est supérieur au bruit, même si celui-ci persiste à un niveau légèrement inférieur au signal utile.

Le circuit à seuil 7 impose une valeur de seuil sl déterminant, s'il est atteint, une coupure entre l'amplificateur 4 et le détecteur 2. Sinon, l'amplificateur 4 est connecté au détecteur 2. Le seuil de silence correspond donc à la valeur du niveau HF causant ladite coupure.

Si on suppose que le seuil de silence peut être réglé manuellement, comme cela était pratiquement toujours le cas dans la technique antérieure, le fonctionnement serait le suivant pendant les huit périodes illustrées en a) sur la figure 2.

Pendant la période t1, le signal HF est formé par du bruit de niveau n1 ce qui donne en b) une tension négative Vd1 à la sortie du détecteur 2. On suppose que l'utilisateur a choisi manuellement à l'aide du potentiomètre 10 un réglage de seuil de silence bas, ce qui signifie en c) qu'une tension positive Vml de faible valeur est appliquée sur le noeud de sommation 8 par le circuit de réglage manuel 10. Les tensions Vd et Vm sont de polarités opposées et leurs valeurs sont telles que la tension Vs résultant de la sommation au noeud 8 et représentée en d) est légèrement négative et en tout cas nettement inférieure au seuil sl (tension Vs1). Par conséquent, l'amplificateur 4 est connecté au détecteur 2 et le bruit est perceptible dans le haut-parleur 5.

Pendant la période t2, on suppose que l'utilisateur ne veut plus entendre de bruit dans le haut-parleur 5. A cet effet, toujours manuellement à l'aide du potentiomètre 10, il rehausse le seuil de silence en augmentant la tension en c) à la valeur Vm2 dans une mesure telle que la tension en d) atteigne juste le seuil de blocage s1. Le circuit interrupteur 3 déconnecte alors l'amplificateur 4 du détecteur 2 de sorte que le haut-parleur 5 reste silencieux.

La période t3 correspond à l'apparition dans le signal HF d'une porteuse pl (graphique a) susceptible de véhiculer de l'information utile. Cette porteuse a un niveau supérieur au bruit. La tension négative détectée augmente et la valeur en b) diminue jusqu'au niveau Vd2, la tension Vm restant maintenue au même niveau Vm2. Dans ces conditions, la tension Vs en d) descend en dessous du seuil sl, de sorte que le comparateur 6 commande le circuit interrupteur 3 pour connecter l'amplificateur 4 au détecteur 2. La communication utile contenue dans la porteuse pl pourra être perçue dans le haut-parleur. Pendant la période t2, la tension Vm avait été réglée juste au seuil de silence, le léger incrément du niveau HF en a) dû à la porteuse pl a déterminé la mise en fonctionnement de l'amplificateur 4.

Pendant la période t4, ni le niveau du signal HF, ni le réglage manuel n'a changé, mais la porteuse pl a disparue ou elle est noyée dans le bruit lequel a augmenté de niveau. Par conséquent, les valeurs des tensions Vd en b) et Vs en d) sont maintenues et l'amplificateur 4 reste connecté. Le haut-parleur reproduit le bruit.

Pendant la période t5, la tension de réglage manuel a été retouchée pour obtenir de nouveau le silence (valeur Vm3 en c)). Ceci conduit à une augmentation de la tension Vs en d) jusqu'au seuil s1 et à une coupure de l'amplificateur 4.

La période t6 correspond à une nouvelle augmentation du niveau de bruit reçu n3. La tension Vd en b) a diminué (valeur Vd3) et la tension de réglage Vm en c) n'étant pas modifiée par l'opérateur, la tension Vs en d) devient inférieure au seuil sl et l'amplificateur 4 est connecté. Le haut-parleur 5 reproduit le bruit.

La période t7 a les mêmes conséquences que la période t5 et la période t8 a les mêmes conséquences que la période t3, à part les niveaux des divers signaux. Pendant la période t8 le signal haute fréquence contient de nouveau une porteuse p2 contenant une communication utile.

Les cas qui viennent d'être examinés font ressortir clairement les inconvénients d'un tel réglage manuel. En effet, si le seuil de silence est réglé par exemple pour supprimer le bruit de la période t5 (Vm = Vm3) et si par la suite le bruit diminue, par exemple pour atteindre le niveau inférieur de la période t3, la porteuse pl apparaissant pendant cette période ne sera pas perçue, car le haut-parleur 5 est alors coupé étant donné que la tension Vs en d) continue à atteindre le seuil sl. La communication utile ne pourra alors pas passer vers le haut-parleur.

On remédie à ce problème grâce à l'invention en prévoyant des moyens de réglage automatiques du seuil de silence, le potentiomètre 10 devenant ainsi inutile.

Ainsi, suivant l'invention, la sortie du détecteur 2 est connectée à un étage de filtrage 12, lui-même relié à un étage de détection 13. La sortie de cet étage de détection 13 fournit un signal de réglage automatique Vb en e) appliqué à l'inverseur 11 de manière à pouvoir être transmis au noeud de sommation 8, lorsque cet inverseur 11 est placé dans la position correspondante de réglage automatique du seuil de silence.

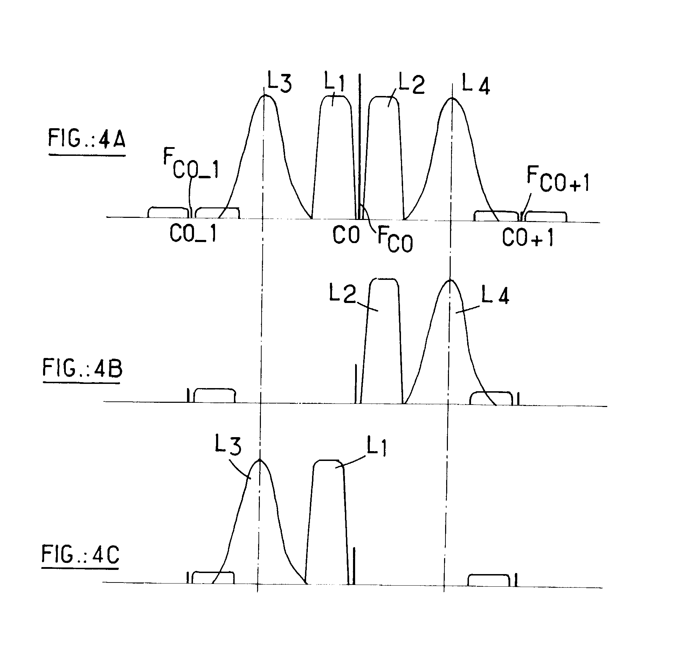

La figure 3 représente un exemple de réalisation du filtre 12 utilisé pour la mise en oeuvre de l'invention. Une diode zener 14 permet de déterminer le niveau continu de travail du filtre. Elle est connectée en série avec une résistance R6 sur une source de tension (non représentée) qui délivre une tension Vcc. Dans le présent exemple, l'étage de filtrage 12 est composé de deux sections identiques de filtrage 12A et 12B connectées en série entre une entrée 15 et une sortie 16. La bande passante des deux sections de filtrage 12A et 12B est ajustée à une gamme supérieure à 3000 Hz, c'est-à-dire au-dessus de la gamme des fréquences vocales, cette gamme du filtre allant de préférence de 3000 à 8000 Hz, une réalisation pratique utilisant de préférence une gamme de 4000 à 7000 Hz.

Les valeurs des composants des deux sections, indiquées sur la figure 3 correspondent à cette dernière gamme préférentielle, mais il convient de noter que ces valeurs ne sont données ici qu'à titre d'exemple, de même d'ailleurs que les valeurs des composants de l'étage de détection 13. Chaque section de filtrage comprend un amplificateur opérationnel 17 qui peut être du type TL082 par exemple, disponible dans le commerce. Cet amplificateur est destiné notamment à augmenter le niveau du signal, compte tenu du fait que les circuits d'accord du récepteur ont tendance à atténuer les parties du spectre situées en dehors de la bande de fréquences du signal utile de communication.

La sortie 16 de la deuxième section de filtrage 12B est connectée à l'étage de détection 13 qui comprend un redresseur à double alternance composé de diodes D2 et D3 et d'un condensateur de lissage C7. Ce redresseur est relié au montage en série d'une résistance R8, d'un potentiomètre de réglage RV1 et d'une diode D4. Le potentiomètre RV1 est destiné à ajuster le niveau de base de l'étage de détection 13. Il est ajusté une fois pour toutes en usine et son rôle n'est donc en aucun cas comparable à celui du potentiomètre 10 qui permet le réglage manuel du seuil de silence. D'ailleurs, le potentiomètre RV1 peut être remplacé éventuellement par des résistances fixes montées directement en usine.

Les figures 4A à 4C illustrent graphiquement la mise en oeuvre de l'invention par la représentation d'un spectre de fréquences apparaissant à l'entrée du détecteur 2, le récepteur étant accordé sur un canal C0 de fréquence porteuse F_{C0}, le spectre comprenant également les signaux, fortement atténués par les étages d'accord du récepteur, des canaux adjacents C0-1 et C0+1, respectivement de fréquences porteuses F_{C0-1} et F_{C0+1}.

La figure 4A montre le cas de la réception d'un signal en modulation d'amplitude à double bande latérale ou en modulation de fréquence. L'écart entre les fréquences porteuses F_{C0}, F_{C0-1} et F_{C0+1} est de 10 kHz dans l'exemple représenté qui concerne plus particulièrement la bande des communications entre particuliers (citizen's band) dont les canaux se situent entre 26 et 28 MHz selon les législations des pays.

Le graphique de la figure 4A montre, d'une part, les lobes L1 et L2 des deux bandes latérales utiles s'étendant sur une gamme de fréquences d'environ 3000 Hz de part et d'autre de la fréquence centrale porteuse F_{C0}, et d'autre part, deux lobes L3 et L4 qui délimitent des bandes latérales ne contenant pas d'information relative aux communications utiles et sur les audiofréquences correspondantes est donc ajusté l'étage de filtrage 12. L'énergie représentée par ces bandes latérales L3 et L4 est fonction du niveau de bruit global qu'atteint l'antenne du récepteur et qui apparaît donc à la sortie du détecteur 2. Il en résulte que la sortie 16 de l'étage de filtrage 12 fournit un signal dont l'amplitude sera variable en fonction de ce niveau de bruit reçu. Ce signal est redressé dans l'étage de détection 13 qui élabore la tension continue Vb dont la valeur est une fonction du niveau de bruit reçu. En d'autres termes, les variations de la tension Vb en e) de la figure 2 représentent une information par laquelle le seuil de silence peut être ajusté automatiquement pour tenir compte des conditions de réception sous lesquelles travaille le récepteur et ce sans être influencée par l'énergie contenue dans les lobes L1 et L2 véhiculant les communications utiles. L'ajustement du seuil de silence est ainsi automatique et le niveau de ce seuil correspondra toujours à la valeur souhaitée pour, d'une part éliminer le bruit parasite dans le haut-parleur pendant les périodes de silence pendant lesquelles aucun signal utile n'est reçu, et d'autre part transmettre au haut-parleur avec un niveau correct, le signal utile dès qu'il parvient au récepteur. En effet, ce signal utile provoquera l'apparition à la sortie du détecteur 2 d'une tension qui après sommation dans le noeud 8 constitue une tension (Vauto en f)) inférieure au seuil de silence, ce qui aura pour effet de coupler l'amplificateur 4 au détecteur 2.

Les figures 4B et 4C montrent que le concept de l'invention peut être appliqué également lorsque l'on est en présence d'une modulation d'amplitude à bande latérale unique qui est la bande supérieure dans la figure 4B et inférieure dans la figure 4C.

Les graphiques e) et f) de la figure 2 illustrent comment l'étage de filtrage 12 et l'étage de détection 13 interviennent dans le réglage automatique du seuil de silence. On voit clairement que la tension Vb en e) suit exclusivement le niveau de bruit dans le signal HF pendant toutes les périodes tl à t8. Il en résulte, en considérant par exemple les périodes t3 et t4, que dans le cas du réglage automatique (inverseur 11 dans la position représentée en traits pleins sur la figure 1), la tension Vauto (graphique f) présente des valeurs différentes pendant ces périodes alors que dans le cas du réglage manuel, la tension Vs en d) présente les mêmes valeurs. Par conséquent, en mode automatique dans lequel le commutateur 11 est dans la position représentée sur la figure 1, le haut-parleur sera ouvert pendant la période t3 pour faire entendre la communication utile contenue dans la porteuse pl, mais il sera fermé pendant la période t4 au lieu d'être ouvert comme dans le cas du réglage manuel.

De même, pendant la période t6, la tension Vauto en f) commande le silence malgré le fait qu'un niveau de bruit plus élevé se présente capable dans le cas du réglage manuel de provoquer la connexion du-haut-parleur 5.

En résumé, du fait de l'invention, en mode de réglage automatique du seuil de silence, le comportement du récepteur sera modifié par rapport au comportement en mode de réglage manuel de ce seuil, pendant les périodes tl, t4 et t6 dans le sens d'un réglage automatique du seuil de silence sans que l'utilisateur ait à ajuster manuellement celui-ci.

Il est évident, par ailleurs qu'en mode de réglage automatique du seuil de silence, on supprime le risque que l'utilisateur règle ce seuil à une valeur trop élevée lui empêchant de percevoir des communications dont le niveau HF est légèrement supérieur au niveau de bruit.

Enfin, on remarquera que, comme le montre la figure 1, les modes de réglage automatique et manuel peuvent coexister dans un même circuit de blocage automatique selon l'invention à réglage automatique du seuil de silence, afin de donner à l'utilisateur l'option de faire travailler le récepteur dans l'un ou l'autre de ces modes. Il est clair cependant que la présence des éléments assurant le réglage manuel (potentiomètre 10) n'est pas obligatoire pour que l'invention puisse pleinement être mise en pratique.

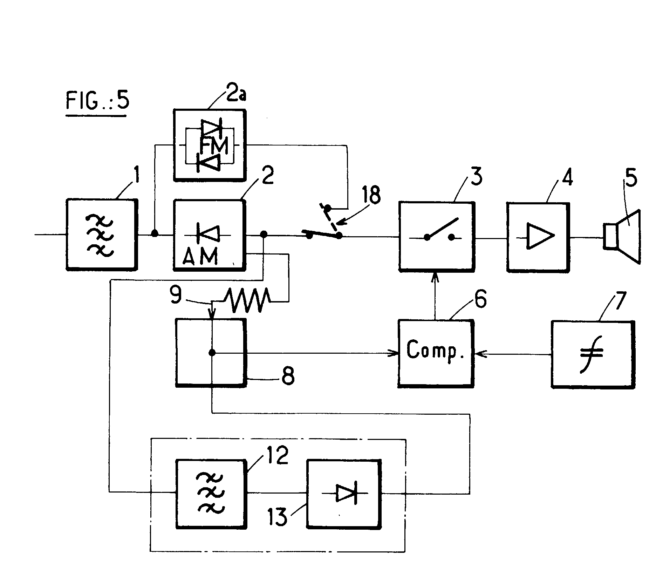

La figure 5 montre une variante de l'implantation du circuit de blocage automatique selon l'invention à réglage automatique du seuil de silence, dans un récepteur radio mixte pouvant, au choix, recevoir des signaux en modulation d'amplitude et des signaux en modulation de fréquence, comme cela est classique. Dans ce cas, l'étage de fréquence intermédiaire 1 est connecté à un détecteur 2 de modulation d'amplitude auquel est prélevé le signal d'entrée pour le filtre 12 et le signal de niveau HF pour le sommateur 8. L'étage de fréquence intermédiaire est également relié à un détecteur de modulation de fréquence 2a, l'un ou l'autre détecteur 2 ou 2a pouvant être branché sur le commutateur 3 à l'aide d'un sélecteur 18. On notera que le cas de la figure 5 illustre le fait que le circuit de blocage selon l'invention peut être dépourvu de possibilité de réglage manuel du seuil de silence.

## Revendications

1. Récepteur radio agencé pour recevoir des émissions comprenant une porteuse haute fréquence sur laquelle sont modulées en amplitude des communications audiofréquence utiles, ledit récepteur comportant
- des circuits d'accord (1) délivrant un spectre de fréquence avec au moins une bande latérale comprenant au moins un lobe (L1, L2) délimitant les communications utiles à recevoir et au moins un lobe (L3, L4) ne contenant pas d'information relative aux communications utiles,
- au moins un premier détecteur (2) fournissant un signal audiofréquence représentant lesdites communications et une première tension continue représentant le niveau de la porteuse haute fréquence reçue,
- des moyens d'amplification (4) dudit signal audiofréquence,
- un transducteur sonore (5) connecté auxdits moyens d'amplification,
- des moyens interrupteurs commandés (3) connectés entre ledit premier détecteur (2) et lesdits moyens d'amplification (4) et capables de bloquer le passage dudit signal audiofréquence dudit premier détecteur (2) vers ledit transducteur sonore (5), et
- un circuit de blocage automatique destiné à engendrer un signal de commande desdits moyens interrupteurs (3) en fonction d'un seuil de silence déterminé,
- ledit circuit de blocage automatique comportant
(i) des moyens de filtrage et de détection (12, 13) comprenant un filtre passe-bande connecté à un second détecteur (13) pour engendrer une seconde tension continue, et
(ii) des moyens pour faire la somme desdites tensions continues pour en fonction de cette combinaison engendrer ledit signal de commande,
la sortie desdits moyens pour faire la somme (8) étant reliée à un comparateur (6) connecté également à des moyens de fixation de seuil (7) pour élaborer ledit signal de commande par comparaison à une valeur de seuil fixe prédéterminée.
caractérisé en ce que
lesdits moyens de filtrage et de détection (12, 13) comprennent un filtre passe-bande (12) ajusté sur le lobe (L3, L4) ne contenant pas d'information relative aux communications utiles, et qui est connecté pour recevoir directement ledit signal audiofréquence (AF) prélevé en aval dudit premier détecteur (2).

2. Récepteur suivant la revendication 1, caractérisé en ce que la bande passante de l'étage de filtrage (12) est ajustée pour que la fréquence de coupure inférieure soit égale ou supérieure à 3000 Hz.

3. Récepteur suivant la revendication 1 ou la revendication 2, caractérisé en ce qu'il est du type mixte, capable de recevoir des émissions en modulation d'amplitude et en modulation de fréquence et comportant à cet effet un détecteur AM et un détecteur FM et ledit détecteur AM (2) est raccordé auxdits moyens de filtrage et de détection (12, 13).

4. Récepteur suivant l'une quelconque des revendications 2 à 4, caractérisé en ce que ledit filtre (12) présente une bande passante dont la fréquence de coupure supérieure est inférieure ou égale à 8000 Hz.

5. Récepteur suivant la revendication 4, caractérisé en ce que la bande passante dudit filtre (12) est sitée entre 4000 et 7000 Hz.

6. Récepteur suivant l'une quelconque des revendications précédentes, caractérisé en ce qu'il comprend également des moyens de commande (10) manuels pour engendrer manuellement une tension faisant office de ladite seconde tension continue, et des moyens (11) pour commuter entre ledit second détecteur (13) et lesdits moyens de commande manuels (10).

## Patentansprüche

1. Empfänger, der zum Empfang solcher Sendungen eingerichtet ist, bei denen die Amplitude eines hochfrequenten Trägers durch tonfrequente Nutzinformationen moduliert ist, bestehend aus
- Abstimmkreisen (1), welche ein Frequenzspektrum mit wenigstens einem Seitenband erzeugen, das wenigstens eine, die zu empfangenden Nutzinformationen begrenzende Keule (L1, L2) und wenigstens eine, keine Information bezüglich der Nutzinformationen enthaltende Keule (L3, L4) aufweist,
- wenigstens einem ersten Demodulator (2), der ein die genannten Informationen darstellendes Tonfrequenzsignal und eine erste, das Niveau des empfangenen hochfrequenten Trägers darstellende Gleichspannung erzeugt,
- Mitteln (4) zur Verstärkung des Tonfrequenzsignals,
- einem Schallübertrager (5), der mit den genannten Verstärkungsmitteln in Verbindung steht,
- gesteuerten Unterbrechungsmitteln (3), die zwischen dem genannten ersten Demodulator (2) und den genannten Verstärkungsmitteln (4) angeordnet sind und die dazu geeignet sind, den Durchgang des Tonfrequenzsignals des ersten Demodulators (2) in Richtung auf den Schallübertrager (5) zu sperren und
- einem automatischen Sperrkreis, der dazu bestimmt ist, ein Steuersignal für die genannten Unterbrechungsmittel (3) zu erzeugen, und zwar in Abhängigkeit von einem vorher bestimmten Ruhegrenzwert,
- wobei der automatische Sperrkreis aus
(i) Filter- und Demodulationsmitteln (12,13), die ein Bandpaßfilter aufweisen, welches mit einem zweiten Demodulator (13) in Verbindung steht, um eine zweite Gleichspannung zu erzeugen und
(ii) Mitteln zur Summenbildung aus den genannten Gleichspannungen besteht, um in Abhängigkeit von dieser Kombination ein Steuersignal zu erzeugen,
wobei der Ausgang der genannten Mittel zur Summenbildung an einen Komparator (6) angeschlossen ist, der gleichermaßen mit den Mitteln zur Festsetzung des Grenzwertes (7) in Verbindung steht, um aus dem Vergleich mit einem vorherbestimmten festen Grenzwert das Steuersignal zu bilden,
dadurch gekennzeichnet,
- daß die genannten Filter- und Demodulationsmittel (12,13) ein Bandpaßfilter (12) aufweisen, welches mit Hinblick auf die Keule (L3, L4) justiert ist, die keine Information bezüglich der Nutzinformationen enthält und welches derart angeschlossen ist, daß es direkt das genannte Tonfrequenzsignal AF empfängt, welches jenseits des genannten ersten Demodulators (2) abgeleitet worden ist.

2. Empfänger nach Anspruch 1, dadurch gekennzeichnet, daß das Bandpaßfilter der Filterstufe (12) dahingehend justiert ist, daß eine untere Grenzfrequenz 3000 Hz entspricht oder oberhalb von 3000 Hz liegt.

3. Empfänger nach Anspruch 1 oder 2, dadurch gekennzeichnet, daß es sich um einen Mischtyp handelt, der zum Empfang von amplituden- oder frequenzmodulierten Sendungen eingerichtet ist und der zu diesem Zweck mit einem zur Demodulation amplitudenmodulierter Schwingungen bestimmten Demodulator AM und einem zur Demodulation frequenzmodulierter Schwingungen eingerichteten Demodulator FM eingerichtet ist, wobei der Demodulator AM (2) mit den genannten Filter- und Demodulationsmitteln (12,13) in Verbindung steht.

4. Empfänger nach einem der Ansprüche 2 bis 4, dadurch gekennzeichnet, daß das Filter (12) einen Bandpaß aufweist, dessen obere Grenzfrequenz unterhalb von 8000 Hz liegt oder 8000 Hz entspricht.

5. Empfänger nach Anspruch 4, dadurch gekennzeichnet, daß sich der Bandpaß des genannten Filters (12) zwischen 4000 Hz und 7000 Hz befindet.

6. Empfänger nach einem der vorangegangenen Ansprüche, dadurch gekennzeichnet, daß er gleichermaßen manuell betätigbare Steuermittel (10) umfaßt, um manuell eine Spannung zu erzeugen, die als die genannte zweite Gleichspannung dient und Mittel (11), die zum Umschalten zwischen dem genannten zweiten Demodulator (13) und den genannten manuellen Steuermitteln (10) bestimmt sind.

## Claims

1. A radio receiver adapted to receive transmissions comprising a radio-frequency carrier onto which wanted audio frequency communications are amplitude modulated, said receiver including
- tuning circuits (1) delivering a frequency spectrum with at least one sideband comprising at least one lobe (L1, L2) delimiting the wanted communications to be received and at least one lobe (L3, L4) containing no information relating to the wanted communications,
- at least a first detector (2) supplying an audio frequency signal representing said communications and a first DC voltage representing the level of the received radio-frequency carrier,
- means (4) for amplifying said audio frequency signal,
- a sound transducer (5) connected to said amplifier means,
- controllable switch means (3) connected between said first detector (2) and said amplifier means (4) and adapted to block the passage of said audio frequency signal from said first detector (2) to said sound transducer (5), and
- an automatic squelch circuit adapted to generate a signal for controlling said switch means (3) in accordance with a particular squelch threshold,
- said automatic squelch circuit including
(i) filter and detector means (12, 13) comprising a band-pass filter connected to a second detector (13) to generate a second DC voltage, and
(ii) means for summing said DC voltages to generate said control signal in accordance with said combination,
the output of said summing means (8) being connected to a comparator (6) also connected to threshold fixing means (7) to produce said control signal by comparison with a predetermined fixed threshold value,
characterised in that
said filter and detector means (12, 13) comprise a band-pass filter (12) tuned to the lobe (L3, L4) containing no information related to wanted communications and which is connected to receive directly said audio frequency signal (AF) from a point downstream of said first detector (2).

2. A receiver according to claim 1 characterised in that the pass-band of the filter stage (12) is adjusted so that the lower cut-off frequency is equal to or greater than 3 000 Hz.

3. A receiver according to claim 1 or claim 2 characterised in that it is of the mixted type capable of receiving amplitude modulation and frequency modulation transmissions and to this end includes an AM detector and an FM detector and said AM detector (2) is connected to said filter and detector means (12, 13).

4. A receiver according to any one of claim 2 to 4 characterised in that said filter (12) has a pass-band the higher cut-off frequency of which is less than or equal to 8 000 Hz.

5. A receiver according to claim 4 characterised in that the pass-band of said filter (12) is in the range 4 000 Hz to 7 000 Hz.

6. A receiver according to any one of the preceding claims characterised in that it also comprises manual control means (10) for manually generating a voltage serving as said second DC voltage and means (11) for switching between said second detector (13) and said manual control means (10).
